Europäisches Patentamt

European Patent Office

Office européen des brevets

(19)

(11) Veröffentlichungsnummer: **0 268 580**

**B1**

(12) # EUROPÄISCHE PATENTSCHRIFT

(45) Veröffentlichungstag der Patentschrift: **29.08.90**

(21) Anmeldenummer: **86903233.4**

(22) Anmeldetag: **03.06.86**

(86) Internationale Anmeldenummer:
**PCT/DE86/00230**

(87) Internationale Veröffentlichungsnummer:
**WO 86/07637 31.12.86 Gazette 86/28**

(51) Int. Cl.⁵: **G 01 V 3/10**

(54) **MAGNETFELDABHÄNGIGER, INDUKTIVER NÄHERUNGSSCHALTER.**

(30) Priorität: **19.06.85 DE 3521816**

(43) Veröffentlichungstag der Anmeldung:
**01.06.88 Patentblatt 88/22**

(45) Bekanntmachung des Hinweises auf die
Patenterteilung:
**29.08.90 Patentblatt 90/35**

(84) Benannte Vertragsstaaten:
**CH DE FR GB LI NL SE**

(56) Entgegenhaltungen:
**DE-A-3 244 507
DE-A-3 423 722
DE-A-3 423 724
US-A-3 271 204**

(73) Patentinhaber: **SOYCK, Gerno
Höveler Weg 47
D-5884 Halver (DE)**
(73) Patentinhaber: **DAHLHEIMER, Peter
Viktoriastrasse 6
D-5885 Schalksmühle (DE)**

(72) Erfinder: **SOYCK, Gerno
Höveler Weg 47
D-5884 Halver (DE)**
Erfinder: **DAHLHEIMER, Peter
Viktoriastrasse 6
D-5885 Schalksmühle (DE)**

(74) Vertreter: **Beckmann, Gerhard
Röntgenweg 1
D-5880 Lüdenscheid/Westf. (DE)**

Courier Press, Leamington Spa, England.

**Beschreibung**

Die Erfindung bezieht sich auf einen induktiven Näherungsschalter in Form eines Hochfrequenzgenerators, dessen Oszillatorspule einen gegenüber einem zu erfassenden Magnetfeld sättigungsempfindlichen Kern aufweist. Diese Anordnung steht in Verbindung mit einer Auswertungsschaltung, welche die von dem Grad der Kernsättigung abhängige Schwingungsamplitude erfaßt und beim Erreichen eines bestimmten Amplitudenwertes einen Schaltvorgang auslöst.

Ein derartiger Näherungsschalter ist aus der DE 32 44 507 bekannt. Danach besteht der Kern der Oszillatorspule aus Ferrit und ist durch einen entsprechenden Jochkörper geschlossen. Infolgedessen läßt sich mit Annäherung des Magnetfeldes bzw. durch dessen Intensivierung immer nur eine Bedämpfung des schwingenden Oszillators erzielen, mit welcher ein Abfallen des Oszillatorstromes einhergeht, wogegen in umgekehrter Richtung wiederum eine Entdämpfung mit Ansteigen des Oszillatorstromes erfolgt. Dabei obliegt es der vorhandenen Auswertungsschaltung, die in den beiden Bewegungsrichtungen auftretenden Änderungen des Oszillatorstromes schalttechnisch umzusetzen.

Dieser Näherungsschalter hat in praxi den Nachteil, entweder nicht ansprechempfindlich genug oder nicht in erforderlicher Kleinbaugröße ausgeführt werden zu können. Hinzu tritt ein schaltungsmäßiger Mehraufwand, um das annäherungsbedingte Abfallen des Oszillatorstromes in einen positiven Schaltbefehl umzusetzen.

Dementgegen wird in der DE 28 29 880 ein berührungslos arbeitender Sicherheitsschalter beschrieben, der einen passiven Steuerkörper fehlerfrei selektieren kann. Hierzu ist eine elektronische Schaltungsanordnung vorgesehen, deren Hochfrequenzoszillator nur auf eine Annäherung der (zunächst fehlenden) 2. Hälfte des Ferrit-Schalenkerns seiner Oszillatorspule mit einem Anstieg der Schwingungsamplitude reagiert, wogegen die Anordnung anderen ferromagnetischen Materialien gegenüber, die in den HF-Überwachungsbereich gelangen, unempfindlich bleißt.—Eine derartige Anordnung ist jedoch nicht nur auf sehr geringe Funktionsabstände angewiesen und an exakte Konstruktionsmaßnahmen gebunden, sondern ebenfalls mit einem beträchtlichen Schaltungsaufwand belastet, was ihren Einsatz erschwert und verteuert.

In Anbetracht dessen liegt der Erfindung die Aufgabe zugrunde, einen Näherungsschalter der eingangs bezeichneten Art in physikalischer Beziehung effizienter auszubilden und zugleich bezüglich seiner Baugröße und im Kostenaufwand zu reduzieren.

Zur Lösung dieser Aufgabe bildet die Erfindung einen induktiven Näherungsschalter nach dem Oberbegriff des Patentanspruchs 1 dahingehend aus, daß dem offenen Kern der Oszillatorspule unter Bildung eines definierten Luftspalts eine sehr dünne Ankerplatte aus einem weichmagnetischen Metallglasmaterial oder aus einer Nickel-Eisen-Legierung mit einer derartigen Permeabilitätskurve fest zugeordnet ist, die den Oszillatorstrom bei Intensivierung des magnetischen Feldes vom bedämpften Zustand des Hochfrequenzgenerators definiert ansteigen und umgekehrt bei einer Schwächung dieses Feldes den Hochfrequenzgenerator definiert wieder in den bedämpften Zustand abfällen läßt.

Gemäß einer Weiterbildung der Erfindung ist nach den Merkmalen der Ansprüche 2 oder 3 vorgesehen, daß die Ankerplatte eine besondere geometrische Form aufweist.

Gemäß dem Merkmal des Anspruchs 4 können der Ankerplatte an sich selbst oder in ihrer Nähe ein oder mehrere Permanentmagnetstücke zugeordnet sein.

Einer Alternative der Erfindung gemäß ist es nach den Merkmalen des unabhängiger Anspruchs 5 ebenfalls möglich, die luftspalt-beabstandete Ankerplatte als ein spitz zulaufendes oder kugelförmiges Gebilde auszugestalten, welches aus einem weichmagnetischen Metallglasmaterial oder aus einer Nickel-Eisen-Legierung oder aus Ferrit besteht und mit einer Breitseite gegen das zu erfassende Magnetfeld gerichtet ist, während es sich mittels der gegenüber gelegenen Spitze auf dem Ferritkern der Oszillatorspule abstützt. Dabei bildet sich zwischen dem Gebilde und den äußeren Jochschenkeln eines Schalenkerns ein definierter Luftspalt aus. Außerdem bewirkt die Permeabilitätskurve der Ankergebildematerials, daß der Oszillatorstrom bei Intensivierung des magnetischen Feldes aus dem bedämpften Zustand des Hochfrequenzgenerators definiert ansteigt und bei einer Schwängung dieses·Feldes definiert wieder in den bedämpften Zustand abfällt.

Den Hochfrequenzgenerator des Näherungsschalters betreffend, besteht des weiteren gemäß dem Merkmal des Anspruchs 6 die Möglichkeit, die Oszillatorspule an eine hauptsächlich als Luftspule ausgeführte weitere Oszillatorspule anzuschließen und nach Art einer Drossel eingangs- oder ausgangsseitig in den Rückkopplungskreis des Hochfrequenzgenerators einzuschleifen. Demgemäß trägt der Kern dieser Spule dann nur eine Wicklung und weist an Stelle eines Kurzschlußjochs die erfindungsgemäß beabstandete Ankerplatte als Sensorelement des Näherungsschalters auf.

Zur weiteren Erläuterung der Erfindung wird auf die typischen Ausführungsbeispiele in der anliegenden Zeichnung Bezug genommen. Hierbei zeigt:

Fig. 1 den offenen Schalenkern der Oszillatorspule mit luftspalt-beabstandeter Ankerplatte;

Fig. 2 die graphische Darstellung des Oszillatorstroms über dem Annäherungsweg bzw. dem Grad der Intensivierung eines Magnetfeldes;

Fig. 3 das Sensorelement gemäß Fig. 1 mit zwei seitlich auf der Ankerplatte angeordneten Magnetstücke;

Fig. 4 die ankerplatte des Sensorelements gemäß Fig. 3 mit nur einem, seitlich angesetzten Magnetstück;

Fig. 5 das Sensorelement gemäß Fig. 1 mit einem der Ankerplatte beabstandet vorgelagerten Magnetstück;

Fig. 6 den offenen Schalenkern der Oszillatorspule mit einem sich darauf zentral abstützenden keilförmigen Ankergebilde;

Fig. 7 die (zu vereinfachende) Oszillatorschaltung mit Schwingkreis-/Rückkopplungsspule als Sensorelement;

Fig. 8 die Schaltungsanordnung gemäß Fig. 7 mit einem in den Rückkopplungskreis des Oszillators eingesetzten Wicklungsteil als Sensorelement;

Fig. 9 die schematische Ausführung des induktiven Näherungsschalters gemäß Fig. 8.

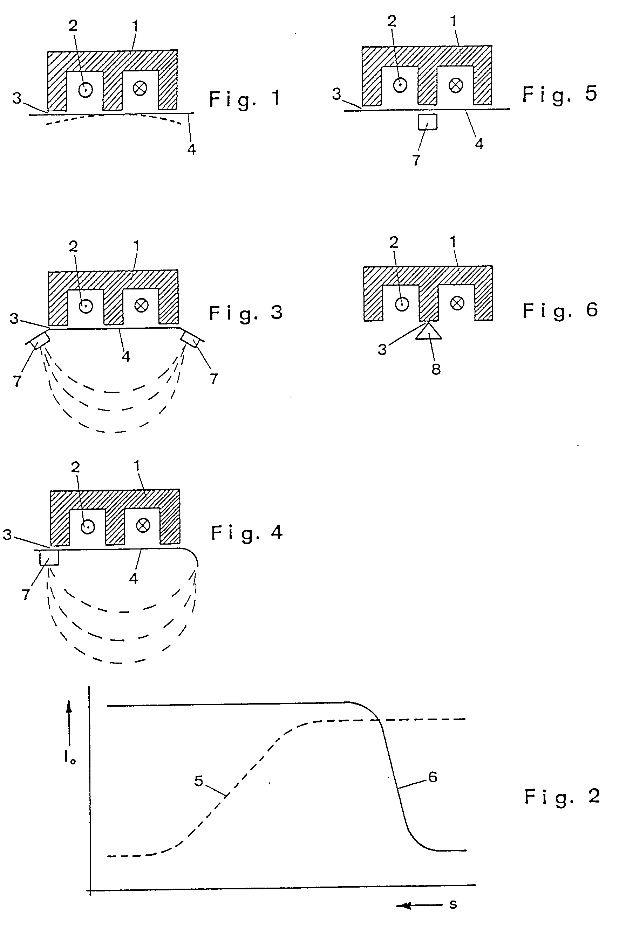

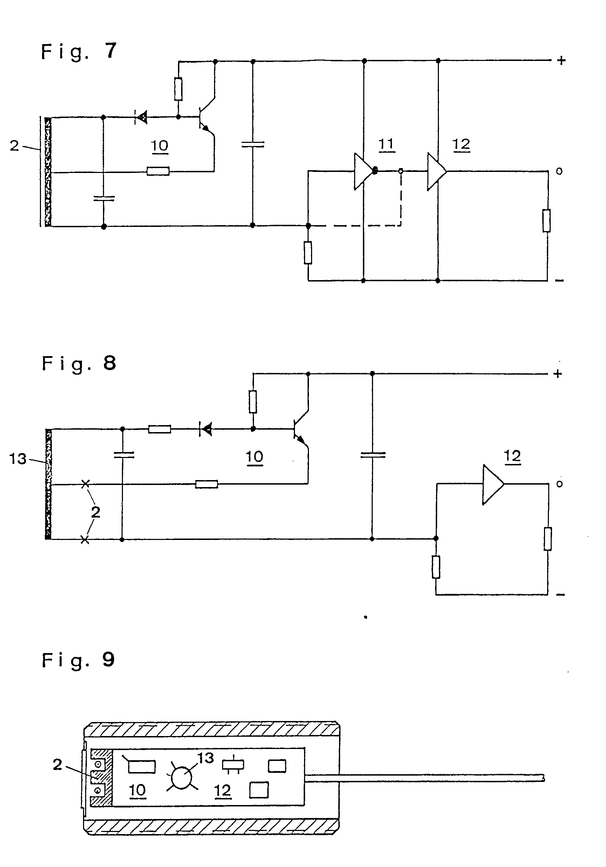

Bei dem in Fig. 1 der Zeichnung dargestellten Sensorelement des induktiven Näherungsschalters handelt es sich beispielsweise um einen konzentrischen Schalenkern 1, um dessen zentralen Schenkel die Oszillatorspule 2 eines Hochfrequenzgenerators gemäß Fig. 7 gewunden ist. Vor bzw. über den Schenkelenden des betreffenden Magnetkerns 1 ist unter Bildung eines definierten Luftspalts 3 eine in Richtung des zu erfassenden Magnetfeldes weisende, folienhafte Ankerplatte 4 angeordnet. Diese Ankerplatte 4 besteht erfindungsgemäß aus einem weichmagnetischen Metallglasmaterial, welches eine etwa um das 25-fache höhere magnetische Leitfähigkeit als Ferrit besitzt, oder aus einer Nickel-Eisen-Legierung.

Aufgrund dessen bildet sich eine konstante Bedämpfung des Hochfrequenzgenerators aus. Dieser Vorgang ist elektronisch mit einer erheblichen Reduzierung des Oszillatorstromes $I_o$ verbunden.—Nähert sich jetzt aber der Ankerplatte 4 von außen ein fremdes Magnetfeld, so wird ab einer bestimmten Intensität oder räumlichen Distanz desselben der Hochfrequenzgenerator entdämpft und demgemäß der Oszillatorstrom $I_o$ auf einen Wert angehoben, der dessen schwingendem Zustand entspricht. Diese Verhältnisse sind aus dem Diagramm gemäß Fig. 2 ersichtlich, in welchem der Oszillatorstrom $I_o$ über dem Annäherungsweg s des Magnetfeldes aufgetragen ist. Hierbei stellt zum Vergleich die gestrichelte Kennlinie 5 das Verhalten eines induktiven Näherungsschalters gemäß der DE 32 44 507 dar, wonach der auszuwertende Oszillatorstrom $I_o$ bei Annäherung des Fremdmagnetfeldes kontinuierlich abnimmt. Demgegenüber zeigt die Kennlinie 6 der erfindungsgemäßen Näherungsschalters erstmalig ein genau umgekehrtes Verhalten: hier steigt der Oszillatorstrom $I_o$ aus der bedämpften Phase bereits eher, d.h. auf weitere Distanz, und ausgeprägter bzw. steiler in die Schwingphase an. Insofern erweist sich der erfindungsgemäße Näherungsschalter nicht nur schaltungstechnisch besser realisierbar, sondern acuh wesentlich ansprechempfindlicher als die bisher bekannten Ausführungen dieser Art.

Da sich die luftspalt-beabstandete Ankerplatte 4 gleicherweise als Dämpfungsglied für den Oszillator wie als eigentliches Sensorelement des induktiven Näherungsschalters darstellt, besteht die Möglichkeit, dessen Anwendung und Funktion nicht nur durch die Wahl einer bestimmten Metallegierung und Dicke, sondern auch durch die geometrische Formgebung der Ankerplatte 4, sowie weiterhin durch eine unmittelbare oder auch mittelbare Vormagnetisierung derselben zu beeinflussen. So kann z.B., wie in der Zeichnung nicht besonders dargestellt, die einem Schalenkern 1 gem. Fig. 1 zugeordnete Ankerplatte 4 bestimmte Formen aufweisen: sie kann beispielsweise größer als die Kernoberfläche, rechteckig, ggf. mit Einschnürungen versehen, zugleich in sich gewölbt ausgestatter sein, oder rund und plan, um eine jeweils typische Reaktion des induktiven Näherungsschalters auf das herankommende oder sich entfernende Fremdmagnetfeld zu erhalten. Dabei können außerdem ein oder zwei auf der Ankerplatte 4 angeordnete oder zu eben dieser in bestimmten Abstand fixierte Permanentmagnetstücke 7 die betreffenden Schaltvorgänge noch weitergehend beeinflussen. Hierzu zeigen die Fig. n 1 und 3 bis 5 nur einige der zahlreichen Ausführungsmöglichkeiten.

Das in Fig. 6 der Zeichnung dargestellt Sensorelement des induktiven Näherungsschalters verwendet an Stelle der folienhaften Ankerplatte (4) ein spitz zulaufendes Kompakt- oder Hohlkörpergebilde 8, das sich mittels seiner Spitze auf dem mittleren Jochschenkel des Schalenkerns 1 der Oszillatorspule 2 abstütz und mit der gegenüberliegenden Breitseite in Richtung des zu erfassenden Fremmagnetfeldes weist. Bei dieser Anordnung kommt trotz der Berührung zwischen Kern und Anker im Umfeld der Berührungsstelle für die magnetischen Kraftlinien ein weitgehend luftspaltentsprechender Leerraum zustande. Diese Ausführung eignet sich somit besonders für kleine Bauformen mit ausgeprägter Richtcharackteristik. Das Gebilde 8 kann zum anderen auch kugelförmig ausgestaltet sein.

Die in Fig. 7 der Zeichnung schematisch dargestellte Schaltungsanordnung des induktiven Näherungsschalters setzt sich aus dem transistorisierten Hochfrequenzgenerator 10 mit der erfindungsgemäß als Sensorelement ausgebildeten Oszillatorspule 2 in Verbindung mit der aus einer Verstärkerstufe 11 und der End(schalt-)stufe 12 bestehenden Auswertungsschaltung zusammen. In Anbetracht der "umgekehrten Funktion" des erfindungsgemäßen Hochfrequenzgenerators 10, bei dem jetzt im Gegensatz zum bekannten Stand der Technik der Anstieg des Oszillatorstromes den Schaltvorgang bewirkt, kann die bisher unverzichtbare Umkehrstufe 11—wie strichliniert angedeutet—entfallen und auch damit der erforderliche Schaltungsaufwand verringert werden.

Des weiteren ist in Fig. 8 der Zeichnung eine demgemäß reduzierte Schaltungsanordnung dargestellt, in welcher das mit Kern und Ankerplatte versehene Sensorelement nicht die gesamte Oszillatorspule, sondern nur einen Wicklungsteil 2 bildet, der an eine weitere Oszillator(luft-)spule 13 angeschlossen ist, und zwar entweder eingangsseitig als Spulenabgriff oder ausgangsseitig als Spulenende im Rückkopplungskreis des Hochfrequenzgenerators 10.

Die gegenständliche Ausführungsmöglichkeit für einen derartig vereinfachten und gewissermaßen miniaturisierbaren Näherungsschalter ist zu guter Letzt in Fig. 9 der Zeichnung nochmals schematisch und vergrößert umrissen.

## Patentansprüche

1. Magnetfeldabhängiger induktiver Näherungsschalter, bestehend aus einem Hochfrequenzgenerator (10), dessen Oszillatorspule (2) einen gegenüber einem zu erfassenden Magnetfeld sättigungsempfindlichen Kern (1) aufweist, in Verbindung mit einer Auswertungsschaltung (11, 12), welche die von dem Grad der Kernsättigung abhängige Schwingungsamplitude erfaßt und beim Erreichen eines bestimmten Amplitudenwertes einen Schaltvorgang auslöst, dadurch gekennzeichnet, daß dem offenen Kern (1) der Oszillatorspule (2) unter Bildung eines definierten Luftspalts (3) eine sehr dünne Ankerplatte (4) aus einem weichmagnetischen Metallglasmaterial oder aus einer Nickel-Eisen-Legierung mit einer derartigen Permeabilitätskurve fest zugeordnet ist, die den Oszillatorstrom ($I_o$) bei Intensivierung des magnetischen Feldes vom bedämpften Zustand des Hochfrequenzgenerators (10) definiert ansteigen und umgekehrt bei einer Schwächung dieses Feldes den Hochfrequenzgenerator (10) definiert wieder in den bedämpften Zustand abfallen läßt.

2. Induktiver Näherungsschalter nach Anspruch 1, dadurch gekennzeichnet, daß die Ankerplatte (4) rechteckig, ggf. mit Einschnürungen versehen, plan oder gewölbt ausgefürt ist und dabei den Kern (1) der Oszillatorspule (2) abdeckt oder seitlich ausladend überragt.

3. Induktiver Näherungsschalter nach Anspruch 1, dadurch gekennzeichnet, daß die Ankerplatte (4) rund und plan ausgeführt ist und dabei den Kern (1) der Oszillatorspule (2) abdeckt.

4. Induktiver Näherungsschalter nach den Ansprüchen 1, 2 oder 3, dadurch gekennzeichnet, daß der Ankerplatte (4) an sich selbst oder in ihrer Nähe ein oder mehrere Permanentmagnetstücke (7) zugeordnet sind.

5. Magnetfeldabhängiger induktivier Näherungsschalter, bestehend aus einem Hochfrequenzgenerator (10), dessen Oszillatorspule (2) einen gegenüber einem zu erfassenden Magnetfeld sättigungsempfindlichen Kern (1) aufweist, in Verbindung mit einer Auswertungsschaltung (11, 12), welche die von dem Grad der Kernsättigung abhängige Schwingungsamplitude erfaßt und beim Erreichen eines bestimmten Amplitudenwertes einen Schaltvorgang auslöst, dadurch gekennzeichnet, daß dem offenen Kern (1) der Oszillatorspule (2) ein spitz ausgebildetes oder kugelförmiges Gebilde (8), bestehend aus einem weichmagnetischen Metallglasmaterial oder aus einer Nickel-Eisen-Legierung oder aus Ferrit, angesetzt ist und sich mittels der Spitze bzw. eines Punktes auf dem Magnetkern (1) abstützt, wobei sich zwischen dem Gebilde (8) und den äußeren Jochschenkeln eines Schalenkerns (1) ein definierter Luftspalt (3) ausbildet und die Permeabilitätskurve des Gebildematerials derart verläuft, daß sie den Oszillatorstrom ($I_o$) bei Intensivierung des magnetischen Feldes vom bedämpften Zustand des Hochfrequenzgenerators (10) definiert ansteigen und bei einer Schwächung dieses Feldes den Hochfrequenzgenerator (10) definiert wieder in den bedämpften Zustand abfallen läßt.

6. Induktiver Näherungsschalter nach einem der Ansprüche 1 bis 5, dadurch gekennzeichnet, daß die Oszillatorspule (2) an eine hauptsächlich als Luftspule ausgeführte weitere Oszillatorspule (13) angeschlossen wird und nach Art dieser Drossel eingangs- oder ausgangsseitig in den Rückkopplungskreis des Hochfrequenzgenerators (10) eingeschleift ist.

## Revendications

1. Commutateur de proximité inductif assujetti au champ magnétique, se composant d'un générateur à haute fréquence (10) dont la bobine d'oscillateur (2) comporte un noyau (1) sensible à la saturation en présence d'un champ magnétique à détecter, en combinaison avec un circuit d'évaluation (11, 12) qui détecte l'amplitude d'oscillation dépendant du degré de saturation du noyau et qui déclenche un processus de commutation lorsqu'une valeur déterminée de l'amplpude est atteinte, caractérisé en ce qu'il est adjoint en position fixe au noyau ouvert (1) de la bobine d'oscillateur (2), avec formation d'un entrefer défini (3), une plaque d'armature très mince (4) en un matériau magnétique doux métalverre ou en un ferronickel ayant une courbe de perméabilité telle qu'en cas d'accentuation du champ magnétique, elle fait croître de façon définie le courant de l'oscillateur ($I_o$) à partir de l'état amorti du générateur à haute fréquence (10) et qu'à l'inverse, en cas d'affaiblissement de ce champ, elle fait retomber de façon définie le générateur à haute fréquence (10) dans l'état amorti.

2. Commutateur de proximité inductif selon la revendication 1, caractérisé en ce que la plaque d'armature (4) est réalisée sous forme rectangulaire, éventuellement munie d'étranglements, plane ou cintrée et recouvre alors le noyau (1) de la bobine d'oscillateur (2) ou fait latéralement saillie en porte à faux.

3. Commutateur de proximité inductif selon la revendication 1, caractérisé en ce que la plaque d'armature (4) est réalisée sous forme ronde et plane et recouvre alors le noyau (1) de la bobine d'oscillateur (2).

4. Commutateur de proximité inductif selon l'une quelconque des revendications 1 à 3, caractérisé en ce qu'il est adjoint à la plaque d'armature (4), sur elle-même ou à son voisinage, une ou plusieurs pièces à aimantation permanente (7).

5. Commutateur de proximité inductif assujetti au champ magnétique, se composant d'un générateur à haute fréquence (10) dont la bobine

d'oscillateur (2) comporte un noyau (1) sensible à la saturation en présence d'un champ magnétique à détecter, en combinaison avec un circuit d'évaluation (11, 12) qui détecte l'amplitude d'oscillation dépendant du degré de saturation du noyau et qui declenche un processus de commutation lorsqu'une valeur déterminée de l'amplitude est atteinte, caractérisé en ce qu'un élément de forme pointue ou sphérique (8), fait d'un matériau magnétique doux métalverre, d'un ferronickel ou d'un ferrite, est appliqué contre le noyau ouvert (1) de la bobine d'oscillateur (2) et prend appui par sa pointe ou en un point sur le noyau magnétique (1), un entrefer défini (3) se formant entre l'élément (8) et les branches de culasse extérieures d'un noyau (1) en forme de pot, et la courbe de perméabilité de la matière de l'élément ayant une allure telle qu'en cas d'accentuation du champ magnétique, elle fait croître de façon définie le courant de l'oscillateur ($I_o$) à partir de l'état amorti du générateur à haute fréquence (10) et qu'en cas d'affaiblissement de ce champ, elle fait retomber de façon définie le générateur à haute fréquence (10) dans l'état amorti.

6. Commutateur de proximité inductif selon l'une quelconque des revendications 1 à 5, caractérisé en ce que la bobine d'oscillateur (2) est raccordée à une autre bobine d'oscillateur (13) réalisée essentiellement sous forme de bobine à air et est intercalée du côté entrée ou sortie, à la manière d'une bobine de self, dans le circuit à réaction du générateur à haute fréquence (10).

**Claims**

1. Magnetic field dependent inductive proximity switch, comprising a high-frequency generator (10), the oscillator coil (2) of which has a core (1), which is saturation-sensitive relative to a magnetic field to be detected, in conjunction with an evaluation circuit (11, 12), which detects the amplitude of oscillation, dependent on the degree of core saturation, and triggers a switching operation upon attainment of a predetermined amplitude value, charucterised in that a very thin armature plate (4), formed from a soft-magnetic metal-glass material or from a nickel-and-iron alloy, is closely associated with the open core (1) of the oscillator coil (2), thereby forming a defined air gap (3), and has a permeability curve which allows the oscillator current ($I_o$) to increase in a defined manner, upon intensification of the magnetic field, from the damped state of the high-frequency generator (10) and, conversely, allows the high-frequency generator (10) to drop again into the damped state, in a defined manner, upon a weakening of this field.

2. Inductive proximity switch according to claim 1, characterised in that the armature plate (4) has a rectangular configuration, possibly provided with constricted portions, a planar configuration or a curved configuration and thereby covers the core (1) of the oscillator coil (2) or protrudes laterally therefrom.

3. Inductive proximity switch according to claim 1, characterised in that the armature plate (4) has a circular and planar configuration and thereby covers the core (1) of the oscillator coil (2).

4. Inductive proximity switch according to claims 1, 2 or 3, characterised in that one or a plurality of permanent magnet parts (7) are associated with the armature plate (4) itself intrinsically or in the vicinity thereof.

5. Magnetic field dependent inductive proximity switch, comprising a high-frequency generator (10), the oscillator coil (2) of which has a core (1), which is saturation-sensitive relative to a magnetic field to be detected, in conjunction with an evaluation circuit (11, 12), which detects the amplitude of oscillation, dependent on the degree of core saturation, and triggers a switching operation upon attainment of a predetermined amplitude value, characterised in that a pointed or spherical structure (8), formed from a soft-magnetic metal-glass material or from a nickel-and-iron alloy or from ferrite, is added to the open core (1) of the oscillator coil (2) and is supported on the magnetic core (1) by means of the tip or a point, a defined air gap (3) being formed beween the structure (8) and the outer yoke arms of a dish-shaped core (1), and the permeability curve of the material of the structure extends in such a manner that it allows the oscillator current ($I_o$) to increase in a defined manner, upon intensification of the magnetic field, from the damped state of the high frequency generator (10) and allows the high-frequency generator (10) to drop again into the damped state, in a defined manner, upon a weakening of this field.

6. Inductive proximity switch according to one of claims 1 to 5, characterised in that the oscillator coil (2) is connected to an additional oscillator coil (13), which is mainly designed as an air coil, and is incorporated into the feedback circuit of the high-frequency generator (10) at the input or output end in the form of a throttle.

Fig. 1

Fig. 5

Fig. 3

Fig. 6

Fig. 4

Fig. 2

1

Fig. 7

2

<u>10</u>

<u>11</u>   <u>12</u>

+

o

_

Fig. 8

13

<u>10</u>

2

<u>12</u>

+

o

_

Fig. 9

2   13

<u>10</u>   <u>12</u>